Europäisches Patentamt

European Patent Office

Office européen des brevets

(19)

(11) Veröffentlichungsnummer: **0 025 531**
A2

# EUROPÄISCHE PATENTANMELDUNG

(21) Anmeldenummer: **80105130.1**

(22) Anmeldetag: **28.08.80**

(51) Int. Cl.³: **H 03 K 4/02,** H 04 L 25/49, G 06 G 7/14

(30) Priorität: **18.09.79 DE 2937728**

(43) Veröffentlichungstag der Anmeldung: **25.03.81**
**Patentblatt 81/12**

(84) Benannte Vertragsstaaten: **AT BE CH DE FR GB IT LI NL SE**

(71) Anmelder: **SIEMENS AKTIENGESELLSCHAFT Berlin und München, Postfach 22 02 61, D-8000 München 22 (DE)**

(72) Erfinder: **Meyer, Fritz, Dr., Wlfostrasse 5, D-8032 Germering (DE)**

(54) Erzeugung mehrstufiger digitaler Signale aus binären Signalen sehr hoher Bitrate.

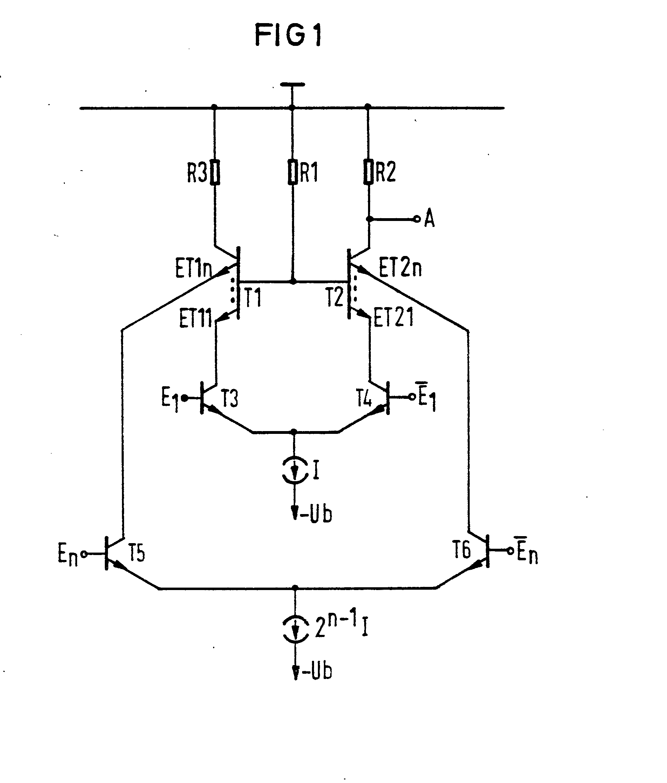

(57) Bei der Erzeugung mehrstufiger digitaler Signale aus binären Signalen sehr hoher Bitrate treten Schwierigkeiten hinsichtlich der gegenseitigen Beeinflussung der einzelnen Amplitudenstufen und hinsichtlich der Rückwirkung auf die Eingangssignale neben den durch die hohe Umschaltgeschwindigkeit bedingten Schwierigkeiten auf. Es wird deshalb eine Schaltungsanordnung vorgeschlagen, bei der mittels zweier basisgekoppelter Multiemitter-Transistoren ein erster basisgekoppelter Differenzverstärker gebildet wird, wobei an die Emitteranschlüsse dieser Multiemitter-Transistoren die Kollektoranschlüsse von emittergekoppelten Differenzverstärkern angeschlossen sind, denen die Eingangssignale zugeführt wird. Die erfindungsgemäße Anordnung ist insbesondere als Binär-Mehrstufenwandler für den Einsatz in PCM-Systemen zur Umwandlung von binären Signalen mit Bitraten von mehreren 100 Mbit/s geeignet (Fig. 1).

SIEMENS AKTIENGESELLSCHAFT     Unser Zeichen
Berlin und München            VPA. **79 P 6 6 6 9** EUR

Erzeugung mehrstufiger digitaler Signale aus binären
Signalen sehr hoher Bitrate

---

Die Erfindung betrifft eine Anordnung zur Erzeugung
$2^n$-stufiger digitaler Signale aus n binären Signalen
sehr hoher Bitrate.

Dabei sollen unter binären Signalen sehr hoher Bitrate
solcher mit einer Bitrate von wenigstens einigen hundert
Mbit/s verstanden werden und n gleich oder größer 2 sein.

Die optimale Nutzung der Kapazität eines Übertragungskanals erfordert eine Anpassung des zu übertragenden
Signales an den Störabstand im Übertragungskanal und an
dessen Bandbreite. Wird als Übertragungsmedium ein Koaxialkabel verwendet, dann ist die Streckendämpfung näherungsweise proportional der Quadratwurzel aus der Signalfrequenz. Daraus ergibt sich eine sehr schnelle Abnahme
des verfügbaren Störabstandes bei zunehmender Übertragungsbreite. Die optimale Ausnutzung der Übertragungs-

Ah 1 Bsl / 13.9.1979

kapazität kann dadurch verbessert werden, daß das digitale Signale nicht in binärer Form, sondern in Form eines Signales mit mehreren Amplitudenstufen, eines sogenannten Mehrstufensignals, übertragen wird. Die Stufenzahl wird dabei so gewählt, daß die Kanalkapazität als Produkt aus dem resultierenden Störabstand und der Bandbreite ein Maximum wird.

Die Erzeugung der Mehrstufensignale erfolgt in der Regel aus binären Ursprungssignalen mittels einer gewichteten Addition. Bei einer gewichteten Addition von binären Signalen sehr hoher Bitrate treten besondere Schwierigkeiten hinsichtlich der exakten Gewichtung und einer rückwirkungsfreien Addition auf.

Die Aufgabe der Erfindung besteht darin, eine Schaltungsanordnung der eingangs erwähnten Art anzugeben, bei der eine möglichst geringe gegenseitige Beeinflussung der einzelnen Amplitudenstufen entsprechend den binären Ursprungssignalen bei hohen Ansprüchen an die Form der Ausgangsimpulse gewährleistet ist.

Erfindungsgemäß wird die Aufgabe durch eine Anordnung entsprechend dem Patentanspruch 1 gelöst. Die angegebene Schaltungsanordnung ist in vorteilhafter Weise vergleichsweise wenig aufwendig, die Realisierung der Multiemitter-Transistoren ist dabei auch durch Parallelschalten von ausgesuchten Einzelemitter-Transistoren möglich.

Ein vorteilhaft einfacher Aufbau unter Verzicht auf Transistor-Stromquellen ergibt sich dadurch, daß als Stromquellen ausreichend hochohmige Widerstände vorgesehen sind, deren Widerstandswerte nach Potenzen von 2 gestuft sind.

Zur Anpassung an die üblicherweise verwendeten Logikpegel ist eine Variante der Erfindung zweckmäßig, bei der dem positiveren Potential der binären Eingangssignale der logische Eins-Zustand zugeordnet ist.

Eine zweckmäßige Schaltungsanordnung zur Kombination von zwei binären Eingangssignalen zu einem quaternären Ausgangssignal ist in Patentanspruch 4 beschrieben.

Die Erfindung soll im folgenden anhand der Zeichnung näher erläutert werden. In der Zeichnung zeigt:

Fig. 1 eine Schaltungsanordnung zur Erzeugung eines $2^n$ -stufigen digitalen Signals aus n binären Eingangssignalen im Prinzip,

Fig. 2 eine Schaltungsanordnung zur Erzeugung eines quaternären Ausgangssignals aus zwei binären Eingangssignalen in einer detaillierten Darstellung und

Fig. 3 ein Impulsdiagramm zu Fig. 2.

Die in der Fig. 1 dargestellte Anordnung dient zur Erläuterung des Schaltungsprinzips, das bei der Erzeugung $2^n$ -stufiger Signale aus n binären Signalen Anwendung findet. Die dargestellte Anordnung enthält zwei Multiemitter-Transistoren T1 und T2, deren Basisanschlüsse miteinander und über einen Widerstand mit Bezugspotential verbunden sind und deren Kollektoranschlüsse als Ausgangsanschlüsse dienen und außerdem über Widerstände getrennt mit Bezugspotential verbunden sind. Die Emitteranschlüsse der Multiemitter-Transistoren sind jeweils getrennt mit den Kollektoranschlüssen weiterer Transistoren verbunden. Dieser Teil der Schaltung bildet einen basisgekoppelten Differenzverstärker. Die Verbindung der Emitteranschlüsse der Multiemitter-Transistoren erfolgt so, daß der mit dem ersten Emitteranschluß des ersten Multiemitter-Transistors verbundene Transistor mit einem Anschluß für ein erstes binäres Eingangssignal verbunden ist und außerdem mit einem zweiten Transistor, dessen Kollektoranschluß mit dem ersten Emitteranschluß des zweiten Multiemitter-Transistors verbunden ist. Diese beiden Transistoren bilden einen emittergekoppelten Differenzverstärker. Der weitere Transistor ist dabei über seinen Basisanschluß mit einem Anschluß E1 für das erste inverse Eingangssignal verbunden.

In entsprechender Weise ist mit dem n-ten Emitteranschluß ET1n des ersten Multiemitter-Transistors ein Transistor T2n+1 verbunden, dessen Basisanschluß mit einem Anschluß En für das n-te Eingangssignal verbunden ist. Der Emitteranschluß dieses Transistors ist zur Bildung des n-ten emittergekoppelten Differenzverstärkers mit dem Emitteranschluß eines Transistors T2n+2 verbunden, dessen Kollektoranschluß mit dem n-ten Emitteranschluß ET2n des zweiten Multiemitter-Transistors und dessen Basisanschluß mit einem Anschluß En für das n-te inverse Eingangssignal verbunden ist. Die Emitteranschlüsse dieser beiden Transistoren sind mit einer Stromquelle verbunden, die den $2^{n-1}$-fachen Strom gegenüber der Stromquelle abgibt, die die Transistoren speist, denen das erste Eingangssignal zugeführt wird. Durch diese nach Potenzen von zwei abgestuften Stromquellen wird die unterschiedliche Bewertung der Eingangssignale erreicht, die für die Erzeugung des mehrstufigen digitalen Signals nötig ist.

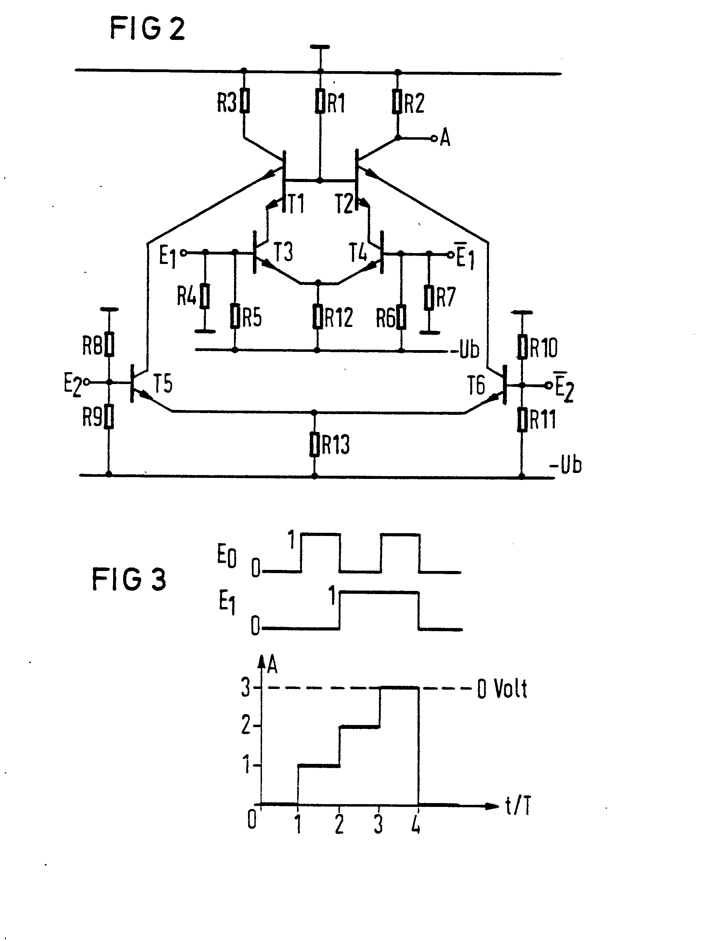

Die in der Fig. 2 dargestellte Schaltungsanordnung dient dem in der Praxis wichtigsten Fall, der Erzeugung eines vierstufigen digitalen Signals aus zwei binären Signalen. Der Aufbau dieser Schaltungsanordnung entspricht weitgehend dem nach dem Prinzipschaltbild der Fig. 1 Zusätzlich sind in dieser Schaltung für die Transistoren T3, T4 bzw. T5 und T6 die Spannungsteilerwiderstände angegeben. Diese Spannungsteilerwiderstände liegen im Bereich weniger kOhm, sie sind damit ausreichend hochohmig, so daß eine unzulässige Bedämpfung der Eingangssignale und eine Veränderung deren Kurvenform nicht zu befürchten ist. Die Kollektorwiderstände der beiden Multiemitter-Transistoren wurden zu etwa 75 Ohm gewählt, um eine Anpassung an das an den Ausgangsanschluß angekoppelte Koaxialkabel sicherzustellen. Die Stromquellen der aus den Transistoren T3, T4 bzw. T5, T6 gebildeten Differenzverstärker wurden durch die Widerstände R12 bzw. R13 realisiert. Da das Verhältnis der Ströme durch R12 und R13 bei 2 : 1 liegen muß wurden die Widerstände zu 120 und 60 Ohm gewählt. Durch diesen Aufbau konnte sichergestellt werden, daß die Zeitintervalle, während denen das Ausgangssignal den gewünschten digitalen Wert annimmt, sich symmetrisch zur Zeichenmitte möglichst weit über die gesamte Zeichenzeit erstrecken und daß die Übergänge zwischen aufeinanderfolgenden Zeichen weitgehend frei von Überschwingern oder Signaleinbrüchen sind.

Die Funktion der Schaltung nach der Fig. 2 soll anhand des Impulsdiagramm nach der Fig. 3 kurz erläutert werden. Dabei wird vorausgesetzt, daß dem positiveren Potential der binären Eingangssignale der logische Eins-Zustand entspricht. Ein vierstufiges digitales Signal kann dementsprechend die Werte o, 1, 2 und 3 annehmen, wobei einem höheren Wert ein entsprechend positiveres Potential zugeordnet ist.

Zunächst kann der Fall betrachtet werden, daß das erste Eingangssignal $E_1=0$ und damit dessen inverser Wert $\bar{E}_1 = 1$ ist und ebenfalls das zweite Eingangssignal $E_2 = 0$ und dessen inverser Wert $E_2 = 1$ ist. In diesem Fall sperren beide Emitter des ersten Multiemitter-Transistors T1, während die beiden Emitter des zweiten Multiemitter-Transistors leiten. Die durch die Widerstände R12 und R13 fließenden Ströme durch den zweiten Multiemitter-Transistor und erzeugen am Kollektorwiderstand R2 das tiefste Potential entsprechend dem Wert 0.

Springt nun das erste Eingangssignal $E_1$ auf den Wert logisch Eins und entsprechend $\bar{E}_1$ auf den Wert logisch Null, dann wird der vom Widerstand R12 stammende kleinere der beiden Emitterströme des Transistors T2 gesperrt. Dadurch entsteht am Kollektoranschluß dieses Transistors ein positiveres Potential, das dem Wert logisch Eins entspricht. Gleichzeitig leitet nun der erste Emitter des ersten Multiemitter-Transistors T1. Die dem Strom I zugeordneten Ladungen in der Basiszone des zweiten Multiemitter-Transistors T2 werden bei diesem Umschaltvorgang direkt in die Basiszone des ersten Multiemitter-Transistors T1 übertragen. Hierdurch wird das für die Verarbeitung von binären Signalen sehr hoher Bitrate benötigte äußerst schnelle Umschalten des Stroms von einem Emitter des einen Transistors auf den entsprechenden Emitter des anderen Transistors erreicht, sofern eine Sättigung dieser Transistoren vermieden wird.

Ist bei einem weiteren Impuls das erste Eingangssignal $E_1 = 0$ und das zweite Eingangssignal $E_2 = 1$, dann wird

der durch den Widerstand R13 fließende größere Emitterstrom vom zweiten auf den ersten Multiemitter-Transistor umgeschaltet. Am Kollektor des zweiter Multiemitter-Transistors T2 entsteht dadurch ein noch positiveres Potential, das in der Fig. 3 dem Wert 2 entspricht.

Sind schließlich beide Eingangssignale $E_1$ und $E_2 = 1$, dann wird der zweite Multiemitter-Transistor völlig gesperrt, so daß an dessen Kollektoranschluß das positivste Potential steht, das in der Fig. 3 dem Wert 3 entspricht.

Mit der dargestellten Schaltungsanordnung konnten binäre Signale mit einer Bitrate von über 500 Mbit/s miteinander kombiniert werden, so daß das erzeugte vierstufige digitale Signal eine Informationsrate von über 1 Gbit/s enthält.

Patentansprüche

1. Anordnung zur Erzeugung $2^n$-stufiger digitaler Signale aus n binären Signalen sehr hoher Bitrate, d a - d u r c h g e k e n n z e i c h n e t , daß ein erster und ein zweiter Multiemitter-Transistor (T1, T2) mit jeweils n Emitteranschlüssen (ET11...ET11n, ET21...ET2n) vorgesehen sind, daß die Basisanschlüsse der beiden Multiemitter-Transistoren miteinander und über einen ersten Widerstand (R1) mit Bezugspotential verbunden sind, daß die Kollektoranschlüsse beider Multiemittertransistoren jeweils getrennt mit Ausgangsanschlüssen und über einen zweiten bzw. dritten Widerstand (R2, R3) mit Bezugspotential verbunden sind, daß der erste Emitteranschluß (ET11) des ersten Multiemitter-Transistors (T1) mit dem Kollektoranschluß eines dritten Transistors (T3) verbunden ist, dessen Basisanschluß mit einem Anschluß (E1) für ein erstes Eingangssignal verbunden ist, daß der Emitteranschluß dieses Transistors mit dem Emitteranschluß eines vierten Transistors (T4) und mit einer Stromquelle (I) verbunden ist, die einen Strom mit einfachem Wert abgibt, daß der erste Emitteranschluß (ET21) des zweiten Multiemitter-Transistors (T2) mit dem Kollektoranschluß des vierten Transistors (T4) verbunden ist, dessen Emitteranschluß mit einem Anschluß ($\overline{E}_1$) für ein erstes inverses Eingangssignal verbunden ist, daß der n-te Emitteranschluß (ET1n) des ersten Multiemitter-Transistors (T1) mit dem Kollektoranschluß eines (2n+1)-ten Transistor (T2n+1) verbunden ist, dessen Basisanschluß mit einem Anschluß für ein n-tes Eingangssignal verbunden ist und dessen Emitteranschluß mit dem Emitteranschluß des (2n+2)-ten Transistor (T2n+2) und mit einer Stromquelle ($2^{n-1}I$) für den $2^{n-1}$ -fachen Strom verbunden

0025531

ist und daß der n-te Emitteranschluß (ET2n) des zweiten
Multiemitter-Transistors (T2) mit dem Kollektoranschluß
des (2n+2)-ten Transistor (T2n+2) verbunden ist.

2. Anordnung nach Anspruch 1, d a d u r c h  g e -
k e n n z e i c h n e t , daß als Stromquellen ausreichend hochohmige Widerstände vorgesehen sind, deren
Widerstandswerte nach Potenzen von 2 gestuft sind.

3. Anordnung nach Anspruch 1, d a d u r c h  g e -
k e n n z e i c h n e t , daß dem positiveren Potential
der binären Eingangssignale (E1...En) der logische Eins-
Zustand zugeordnet ist.

4. Anordnung nach einem der vorhergehenden Patentansprüche, d a d u r c h  g e k e n n z e i c h n e t ,
daß zwei Multiemitter-Transistoren (T1, T2) mit je zwei
Emitteranschlüssen versehen sind, deren Basisanschlüsse
miteinander und über einen ersten Widerstand (R1) mit
Bezugspotential verbunden sind, deren Kollektoranschlüsse
getrennt voneinander mit Ausgangsanschlüssen und einen
zweiten bzw. dritten Widerstand (R2, R3) mit Bezugspotential verbunden sind, daß der erste Emitteranschluß
des ersten Multiemitter-Transistors mit dem Kollektoranschluß eines dritten Transistors (T3) verbunden ist,
dessen Basisanschluß mit einem Anschluß ($E_1$) für ein
erstes Eingangssignal, über einen vierten Widerstand
(R4) mit Bezugspotential und über einen fünften Widerstand (R5) mit Betriebsspannung (-Ub) verbunden ist,
daß der Emitteranschluß des dritten Transistors (T3)
mit dem Emitteranschluß eines vierten Transistors (T4)
und über einen zwölften Widerstand (R12) mit Betriebsspannung (-Ub) verbunden ist, daß der erste Emitteranschluß des zweiten Multiemitter-Transistors (T2) mit dem Kollektoranschluß des vierten Transistors (T4) verbunden ist, dessen Basisanschluß mit einem Anschluß ($E_1$)
für das erste inverse Eingangssignal und außerdem über
einen sechsten Widerstand (R6) mit Betriebsspannung
(-UB) und über einen siebendten Widerstand (R7) mit
Bezugspotential verbunden ist, daß der zweite Emitteranschluß des ersten Multiemitter-Transistors (T1) mit
dem Kollektoranschluß eines fünften Transistor (T5)
verbunden ist, dessen Basisanschluß mit einem Anschluß
($E_2$) für ein zweites Eingangssignal und außerdem über
einen achten Widerstand (R8) mit Bezugspotential und
über einen neunten Widerstand (R9) mit Betriebsspannung
(-Ub) verbunden ist, daß der Emitteranschluß dieses
Transistors (T5) mit dem Emitteranschluß eines sechsten
Transistors (T6) und über einen dreizehnten Widerstand
(R13) mit Betriebsspannung (-Ub) verbunden ist, daß der
zweite Emitteranschluß des zweiten Multiemitter-Transistors (T2) mit dem Kollektoranschluß des sechsten Transistors (T6) verbunden ist, dessen Basisanschluß mit einem
Anschluß ($E_2$) für das zweite inverse Eingangssignal und
außerdem über einen zehnten Widerstand (R10) mit Bezugspotential und über einen elften Widerstand (R11) mit Betriebsspannung (-Ub) verbunden ist.

FIG 1

FIG 2

FIG 3